# EUROPEAN PATENT APPLICATION

(11) **EP 2 818 925 A1**
(43) Date of publication of application: **31.12.2014**
(21) Application number: 13199381.8
(22) Date of filing: 23.12.2013
(51) Int. Cl.: G03F 1/54, G02F 1/1339

(54) **Mask**

(30) Priority: 27.06.2013 CN 201310261540
(71) Applicant: Shanghai Avic Optoelectronics Co. Ltd, Shanghai 201108 (CN); Tianma Micro-Electronics Co., Ltd., Shenzen Guangdong 518052 (CN)
(72) Inventor: Qin, Dandan, 201108 Shanghai (CN); Xia, Zhiqiang, 201108 Shanghai (CN)
(74) Representative: Epping - Hermann - Fischer

(57) **Abstract**

Embodiments of the present disclosure provide a mask for sealant curing. The mask may include an opaque region, a transparent region and a partially transparent region, wherein the transparent region corresponds to a sealant region which is to be cured, and the partially transparent region is disposed between the opaque region and the transparent region. According to the present disclosure, by providing a mask with a partially transparent region, an abnormal display, which is resulted from decomposition of liquid crystal molecules irradiated by UV rays, may be alleviated. Therefore, the produce yield of LCD can be improved.

## Description

### CROSS REFERRENCE TO RELATED APPLICATIONS

The present application claims priority to Chinese patent application No. 201310261540.0, filed on June 27, 2013, and entitled "MASK", the entire disclosure of which is incorporated herein by reference.

### FIELD OF THE DISCLOSURE

The present disclosure generally relates to Liquid Crystal Display (LCD) technology, and more particularly, to a mask for sealant curing irradiated by an ultra-violet (UV) light source and a method for curing a sealant.

### BACKGROUND OF THE DISCLOSURE

As a promising flat panel display device, Liquid Crystal Display (LCD) has been developed rapidly over the past ten years, which has been widely used in various kinds of modern communication devices, such as television, computer, mobile phone and digital camera, etc., because of its advantages of thin thickness, power saving, no radiation and low energy consumption. Currently, the conventional vacuum align technology of LCD includes: coating sealant around a first glass substrate using a device for coating sealant; dropping liquid crystal onto the center of a second glass substrate using an One Drop Fill (ODF) process; bonding the first and second glass substrates in a vacuum state, which is called vacuum align technology; and curing the sealant, which may include: curing the sealant partly by irradiation with Ultraviolet (UV) rays for a short time; curing photosensitive compositions of the sealant in a UV rays curing chamber; and curing the sealant completely in a high temperature furnace. Thus, the process of vacuum alignment technology is accomplished.

Liquid crystal molecules in a LCD panel may decompose and generate mobile ions under UV rays. Such mobile ions are likely to pin on the surface of the glass substrate, which may generate an electric potential difference and cause an incidental image. To avoid decomposition of liquid crystal, a mask may be used to shield the display area from UV rays.

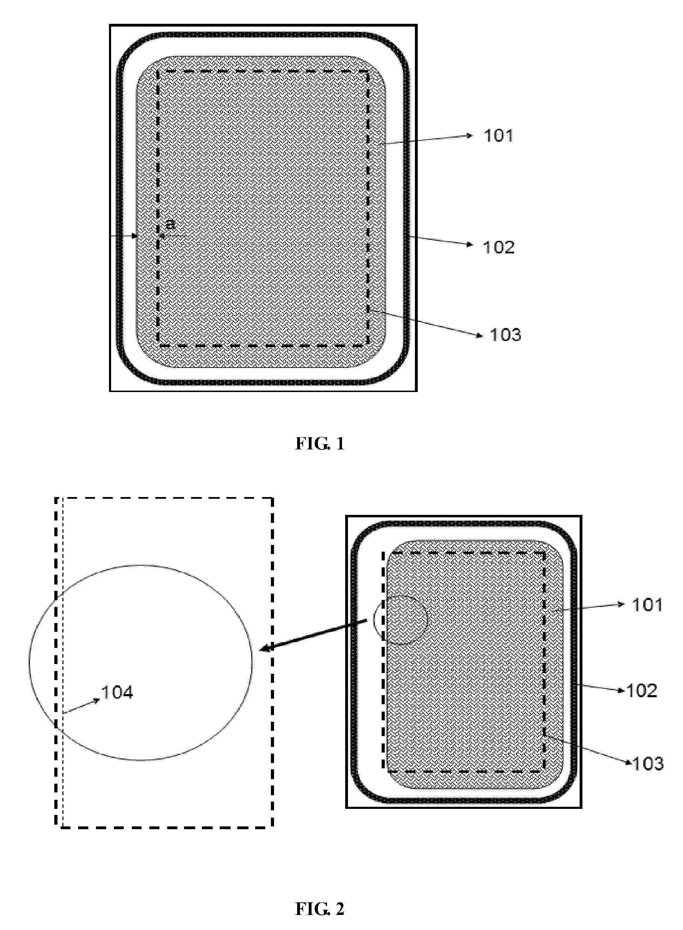

FIG. 1 schematically illustrates a sealant of a LCD cured by UV rays in the prior art. FIG. 2 schematically illustrates a split-screen phenomenon caused by a too large distance between an edge of a mask and an edge of a LCD in the prior art. Referring to FIG. 1, a sealant 102 and a display area 103 are formed on a glass substrate of a LCD. The display area 103 is covered by a mask 101, but the sealant 102 is not covered. Therefore, when irradiated by UV rays, the liquid crystal in the display area 103 of the glass substrate is not subject to UV rays. However, in a narrow bezel design, a distance (marked with "a" in FIG. 1) from an edge of the mask 101 to an edge of the display area 103 of the glass substrate may be too small, thus, a positional deviation between the mask 101 and the glass substrate is likely to exceed the distance "a". Referring to FIG. 2, when the positional deviation is greater than "a", the display area 103 of the glass substrate may not be shielded completely, liquid crystal molecules in a portion of the display area 103 of the glass substrate may be decomposed due to exposure to UV rays, while liquid crystal molecules in the remaining portion of the display area 103 of the glass substrate may stay the same due to shielding of the mask. The decomposition of the liquid crystal molecules would adversely affect display effect, which causes a phenomenon of split screens between the portion of the display area 103 of the glass substrate exposed to UV rays and the remaining portion of the display area 103 of the glass substrate not exposed to UV rays. Thus, a split-screen line 104 may be generated at the edge of the display area 103 of the glass substrate.

Therefore, there is a need to cure the sealant on LCDs efficiently without affecting the active display area of the LCDs.

### SUMMARY

Embodiments of the present disclosure provide a mask for sealant curing, and a sealant curing method for a display of Liquid Crystal Display (LCD).

According to one embodiment of the present disclosure, a mask may include an opaque region, a transparent region and a partially transparent region, wherein the transparent region corresponds to a sealant region which is to be cured, and the partially transparent region is disposed between the opaque region and the transparent region.

According to one embodiment of the present disclosure, a sealant curing method for a panel of Liquid Crystal Display (LCD) may include using the mask described above, when a substrate of a display panel is irradiated by an ultra-violet (UV) light source.

By providing a mask with a partially transparent region according to the present disclosure, an abnormal display effect caused by decomposition of liquid crystal molecules irradiated by UV rays, may be alleviated. Therefore, the production yield of LCD can be improved.

### BRIEF DESCRIPTION OF THE DRAWINGS

FIG. 1 schematically illustrates a sealant of a LCD cured by UV rays in the prior art;
FIG. 2 schematically illustrates a split-screen phenomenon due to a large distance between an edge of a mask and an edge of a LCD in the prior art;
FIG. 3 schematically illustrates a mask for curing a sealant by UV rays according to a first embodiment of the present disclosure;
FIG. 4 schematically illustrates a position relationship between a mask and a glass substrate according to the first embodiment;
FIG. 5 schematically illustrates a mask for curing a sealant by UV rays according to a second embodiment of the present disclosure;
FIG. 6 schematically illustrates another example of a mask for curing a sealant by UV rays according to the second embodiment of the present disclosure;
FIG. 7 schematically illustrates a mask for curing a sealant by UV rays according to a third embodiment of the present disclosure; and
FIG. 8 schematically illustrates another example of a mask for curing a sealant by UV rays according to the third embodiment of the present disclosure.

### DETAILED DESCRIPTION

The disclosure will be described with reference to certain embodiments. It will be understood by those skilled in the art that various changes may be made without departing from the spirit or scope of the disclosure. Accordingly, the present disclosure is not limited to the embodiments disclosed.

Specific details are given in the description to provide a thorough understanding of example embodiments. However, well-known structures, and techniques have been shown without unnecessary detail in order to avoid obscuring the embodiments. It is to be understood that lots of configuration details should be implemented to achieve the specific object described herein, for example, capable of modified to be another embodiment according to actual systems or related commercial limits. Such modification may be complicated and time-consuming, however, is deemed to be routine operation to those skilled in the art.

In order to clarify the objects, characteristics and advantages of the disclosure, the embodiments of the present disclosure will be described in detail in conjunction with the accompanying drawings. It should be noted that elements in the drawings are shown in a simplified manner and not drawn to scale, which helps to improve understanding embodiments of the disclosure.

### First Embodiment

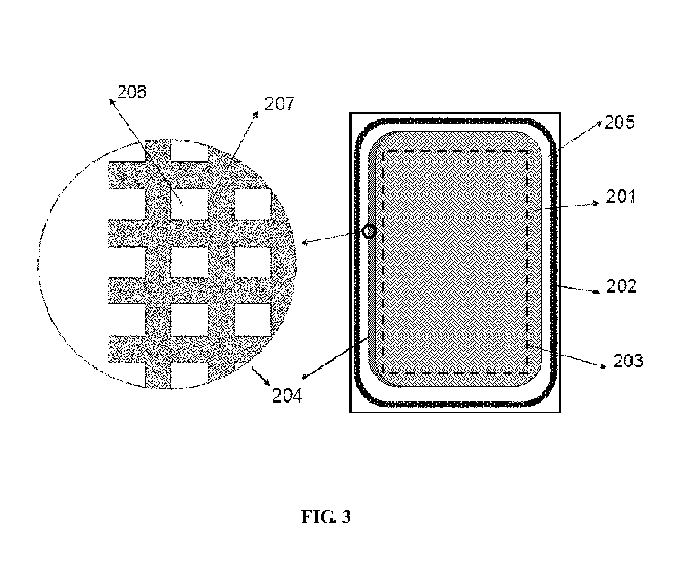

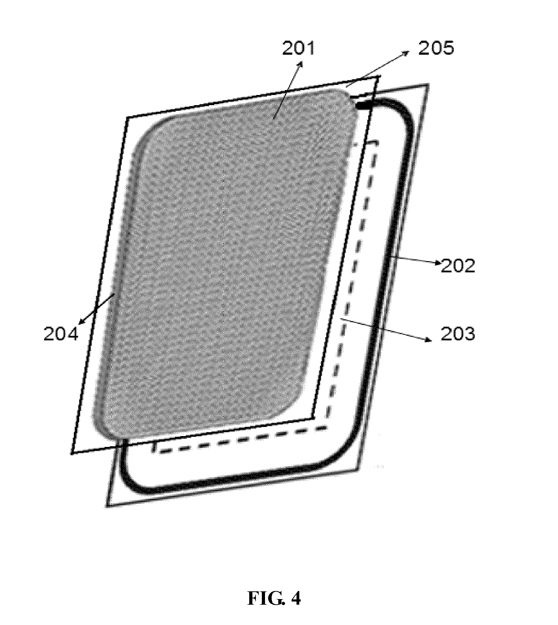

Referring to FIG. 3 and FIG. 4, FIG. 3 schematically illustrates a mask for curing a sealant by UV rays according to a first embodiment of the present disclosure, and FIG. 4 schematically illustrates a position relationship between a mask and a glass substrate according to the first embodiment.

The mask may include an opaque region 201, a transparent region 205 and a partially transparent region 204. The opaque region 201 corresponds to a display region 203 of a glass substrate. The transparent region 205 corresponds to a sealant region 202 which is to be cured. The partially transparent region 204 is between the opaque region 201 and the transparent region 205. The partially transparent region 204, when exposed to UV rays, may allow a portion of the UV rays to pass through the mask and shield another portion of the UV rays.

When the sealant region 202 of the glass substrate is cured by UV rays, the opaque region 201 may shield the display region 203 of the glass substrate, such that the liquid crystal molecules in the display region 203 of the glass substrate may not decompose. If the rightward positional deviation between the mask and the glass substrate is too large, the display region 203 of the glass substrate may not be shielded completely by the opaque region 201. Therefore, a portion of the display region 203 may be covered by the transparent region 205, and a portion of the display region 203 may be covered by the partially transparent region 204. Liquid crystal molecules in these two portions of the display regions are exposed to UV rays. And decomposition of liquid crystal molecules may occur, which may cause abnormal display. However, the partially transparent region 204 disposed between the opaque region 201 and the transparent region 205 is able to shield some UV rays, thus, the proportion of decomposition of liquid crystal molecules in the display region 203 covered by the partially transparent region 204 is less than that in the display region 203 covered by the transparent region 205. Therefore, a transitional display effect, from normal display, partially abnormal display, to completely abnormal display, may be presented on the different regions of the display region 203 which correspond to the opaque region 201, the partially transparent region 204, to the transparent region 205 respectively. The gradual change is hard to be noticeable for human eyes. Therefore, even if there is an alignment positional deviation between a mask and a glass substrate during sealant curing by UV rays, the final products may meet practical requirements. That is, by using the mask for sealant curing by UV rays according to the embodiments of the present disclosure, display uniformity can be improved and production yield can be increased.

According to the first embodiment, the partially transparent region 204 is a grid pattern which is composed of transparent sections 206 and opaque sections 207. A UV rays irradiation on the partially transparent region 204 may pass through the transparent sections 206 to the glass substrate, and may be shield by the opaque sections 207. The density of the transparent sections 206 close to (in the vicinity of) the opaque region 201 is substantially equal to the density in the direction away from the opaque region 201. In some embodiments, the transparent sections 206 may be regularly arranged or arranged in a regular lattice.

In the first embodiment, the partially transparent region 204 is disposed on the left side of the opaque region 201. Therefore, when the mask moves rightwards relative to the glass substrate and an alignment positional deviation is generated, a transitional display region may be generated at the left edge region of the display region 203 due to the existence of the partially transparent region 204. Alternatively, the partially transparent region 204 may be disposed on every one side of the opaque region 201. In some embodiments, the partially transparent region 204 may be disposed between the opaque region 201 and the transparent region 205 and be in the form of a closed ring, i.e., surrounding the opaque region 201, such that abnormal display caused by an alignment positional deviation in either direction and an alignment positional deviation in adjacent directions can be avoided.

The mask for sealant curing provided in the first embodiment of the present disclosure may have the following advantages.
1. By disposing the partially transparent region 204 between the opaque region 201 and the transparent region 205, abnormal display, resulted from decomposition of liquid crystal molecular in the display region 203 which is caused by alignment positional deviation between the mask and the glass substrate, can be alleviated.
2. According to the first embodiment, high accuracy of alignment between the mask and the glass substrate, which is required particularly in production of narrow bezel LCD as the display region 203 is positioned too close to the sealant region 202, is achieved, thereby increasing the production yield.

It should be noted that the mask of the first embodiment is just exemplary, but not limited thereto. In some embodiments, the partially transparent region 204 may have an irregular pattern. For example, the pattern of the opaque sections 207 of the partially transparent region 204 may have a serrate, triangular or trapezoid shape.

### Second Embodiment

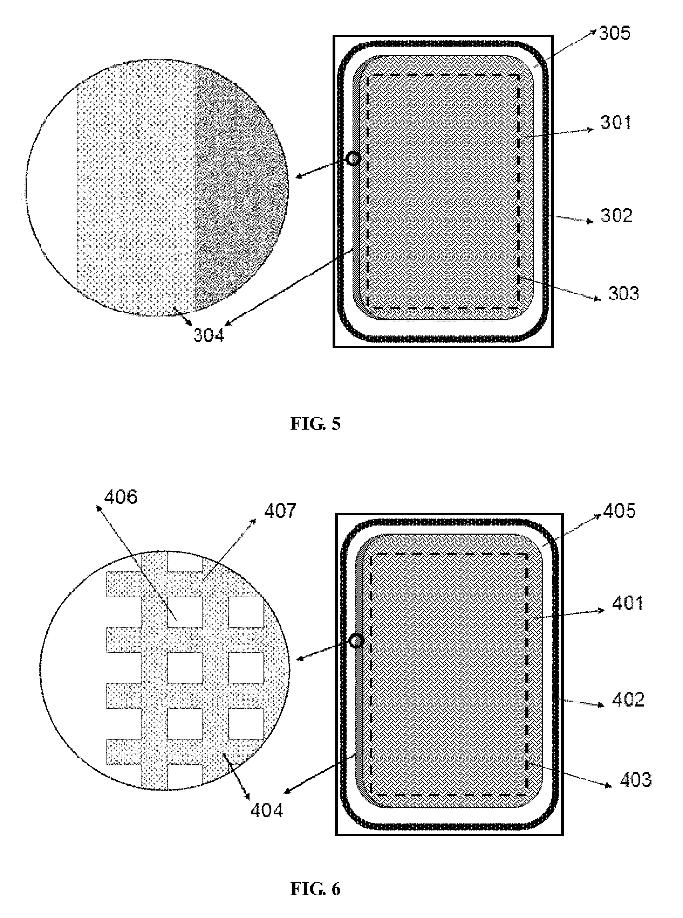

FIG. 5 schematically illustrates a mask for curing a sealant by UV rays according to the second embodiment of the present disclosure. The mask may include an opaque region 301, a transparent region 305 and a partially transparent (semi-transparent, translucent) region 304. Referring to FIG. 5, compared with the mask shown in the first embodiment, the mask of the second embodiment may have its partially transparent region 304 designed to be a half-tone mask. When irradiated by UV rays, the opaque region 301 may shield the UV rays. During sealant curing by UV rays, the UV rays may pass through the transparent region 305 to the corresponding sealant region 302 on the glass substrate. Meanwhile, a portion of the UV rays may pass through the partially transparent region 304 to the glass substrate. If the alignment positional deviation of the mask rightwards relative to the glass substrate is too large, the display region 303 of the glass substrate may be overlapped with the partially transparent region 304 on the left side, because it is not shielded by the opaque region 301. If the alignment positional deviation of the mask rightwards relative to the glass substrate is large to an extent, a portion of the display region 303 may be overlapped with the transparent region 305.

The display region 303 overlapped with the partially transparent region 304 may be irradiated by UV rays, thus, liquid crystal molecules in the display region 303 may decompose. By selecting a predetermined gray level of the partially transparent region 304, the light transmittance of UV rays can be controlled, which causes only a small number of liquid crystal molecules to decompose. In this way, a normal display may not be affected, or an abnormal display is hard to be noticed. Furthermore, an abnormal display may occur in the display region 303 overlapped with the transparent region 305, because it is exposed to UV rays. However, the display effect of the display region 203 from the opaque region 301, the partially transparent region 304, to the transparent region 305 may change gradually, which also may not exhibit a visible display difference.

FIG. 6 schematically illustrates another mask for curing a sealant by UV rays according to the second embodiment of the present disclosure. Referring to FIG. 6, the mask may include an opaque region 401, a transparent region 405 and a partially transparent region 404. In this embodiment, the partially transparent region 404 which is designed to be half-tone mask may be provided with patterns. The pattern of the partially transparent region 404 may be composed of transparent sections 406 and partially transparent sections 407. During sealant curing by UV rays, the mask provided according to the second embodiment shown in FIG. 6 may achieve the same effect described above as the mask shown in FIG. 5. Further, the light transmittance of UV rays can be controlled by selecting a predetermined gray level of the partially transparent sections 407, so as to achieve a desired display effect.

It should be noted that the mask according to the second embodiment is present exemplarily, but not limited thereto. In some embodiments, the partially transparent region 404 may be composed of partially transparent sections and opaque sections.

In some embodiments, the partially transparent region 304, which is designed to be half-tone mask, may include a plurality of districts, where the light transmittance of the plurality of districts may increase gradually in a direction from the opaque region 301 to the transparent region 305. Therefore, a plurality of districts having different display effect may be present in the display region corresponding to the partially transparent region 304. And the abnormal display occurred in the plurality of districts may generate a transition, which makes it difficult to be noticed for people.

### Third Embodiment

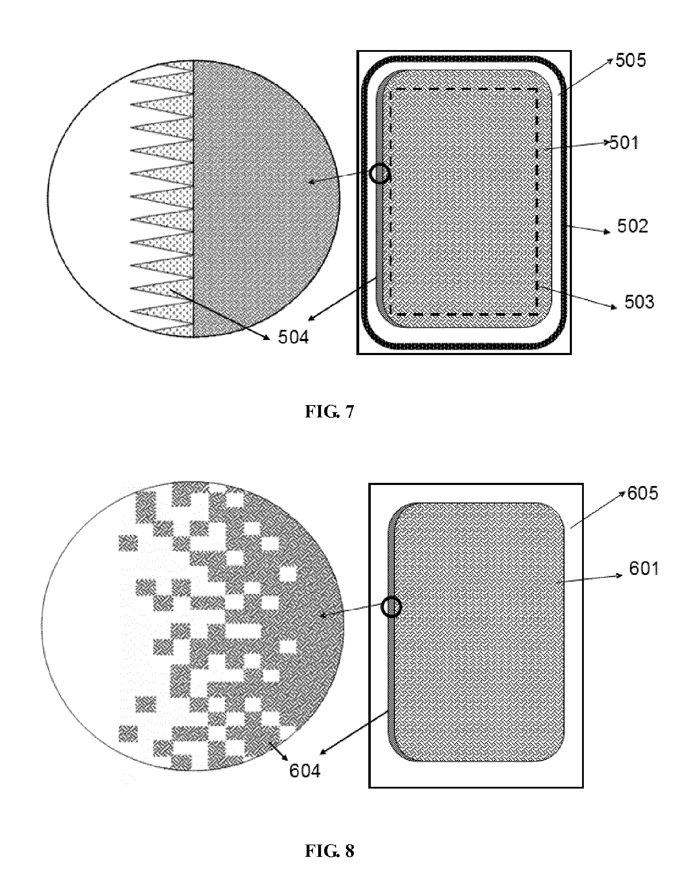

FIG. 7 schematically illustrates a mask for curing a sealant by UV rays according to a third embodiment of the present disclosure. FIG. 8 schematically illustrates another mask for sealant curing by UV rays according to the third embodiment of the present disclosure. Referring to FIG. 7, the mask includes an opaque region 501, a transparent region 505 and a partially transparent region 504. In the third embodiment, compared with the first and second embodiments, the density of the transparent sections of the partially transparent region 504 close to the transparent region 505 is greater than that close to the opaque region 501.

When a LCD sealant region 502 is cured under UV rays, the mask according to the third embodiment may be used to shield the display region of the LCD. When an alignment positional deviation occurs between the mask and the glass substrate, the opaque region 501 fails to shield the display region 503 completely. The UV rays transmittance of the partially transparent region 504 increases gradually in a direction from the opaque region 501 to the transparent region 505. Correspondingly, the proportion of the liquid crystal molecules decomposed increases gradually in the same direction. Therefore, the display effect of the display region 503 changes gradually from the opaque region 501, the partially transparent region 504, to the transparent region 505, without a noticeable display difference.

It should be noted that the mask of the third embodiment is present exemplarily, but not limited thereto. Referring to FIG. 8, the mask includes an opaque region 601, a transparent region 605 and a partially transparent region 604. In some embodiments, the partially transparent region 604, which is disposed between the transparent region 605 and the opaque region 601, may be provided with irregular patterns, such as irregular patterns formed interlaced by transparent sections and opaque sections. In some embodiments, the pattern of the partially transparent region 604 may be composed of opaque sections and partially transparent sections.

Although the present disclosure has been disclosed above with reference to preferred embodiments thereof, it should be understood that the disclosure is presented by way of example only, and not limitation. Those skilled in the art can modify and vary the embodiments without departing from the spirit and scope of the present disclosure.

## Claims

1. A mask for curing sealant, comprising: an opaque region; a transparent region; and a partially transparent region, wherein the transparent region corresponds to a sealant region which is to be cured, and wherein the partially transparent region is disposed between the opaque region and the transparent region.

2. The mask according to claim 1, wherein the partially transparent region comprises a pattern having a regular shape or an irregular shape.

3. The mask according to claim 2, wherein the pattern comprises:
a plurality of opaque sections, a plurality of transparent sections and a plurality of partially transparent sections; or
a plurality of transparent sections and a plurality of opaque sections; or
a plurality of transparent sections and a plurality of partially transparent sections; or
a plurality of opaque sections and a plurality of partially transparent sections.

4. The mask according to claim 3, wherein the plurality of opaque sections have a density in a vicinity of the opaque region that is greater than a density in a direction away from the opaque region.

5. The mask according to claim 3, wherein the plurality of partially transparent sections have a density in a vicinity of the opaque region that is greater than a density in a direction away from the opaque region.

6. The mask according to claims 3, wherein the plurality of partially transparent sections are designed to be a half-tone mask.

7. The mask according to one of claims 2 to 6, wherein the pattern has a grid, serrate, triangular, or trapezoid shape.

8. The mask according to one of claims 1 to 7, wherein the partially transparent region is disposed around the opaque region and in the form of a closed ring.

9. The mask according to one of claims 1 to 7, wherein the partially transparent region is disposed at either side of the opaque region.

10. A sealant curing method for a panel of Liquid Crystal Display (LCD), the method comprising:
irradiating a substrate of a display panel by an ultra-violet (UV) light source using a mask according to any one of claims 1 to 9.
